(19) Europäisches Patentamt
European Patent Office
Office européen des brevets

(11) **EP 1 074 996 B1**

(12) **FASCICULE DE BREVET EUROPEEN**

(45) Date de publication et mention
de la délivrance du brevet:
**16.04.2008 Bulletin 2008/16**

(51) Int Cl.:
***G11C 27/02*** *(2006.01)*

(21) Numéro de dépôt: **00402228.1**

(22) Date de dépôt: **04.08.2000**

(54) **Echantillonneur-bloqueur**

Abtasthalteschaltung

Sample and hold circuit

(84) Etats contractants désignés:
**AT BE CH CY DE DK ES FI FR GB GR IE IT LI LU
MC NL PT SE**

(30) Priorité: **06.08.1999 FR 9910282**

(43) Date de publication de la demande:
**07.02.2001 Bulletin 2001/06**

(73) Titulaire: **E2V Semiconductors
38120 Saint Egreve (FR)**

(72) Inventeurs:
• **Gaillard, Christophe
94117 Arcueil Cedex (FR)**
• **Le Tual, Stéphane
94117 Arcueil Cedex (FR)**

(74) Mandataire: **Lucas, Laurent Jacques
Marks & Clerk France
31-33 Avenue Aristide Briand
94117 Arcueil Cedex (FR)**

(56) Documents cités:
**US-A- 5 457 418**

• **PATENT ABSTRACTS OF JAPAN vol. 1997, no.
08, 29 août 1997 (1997-08-29) & JP 09 091988 A
(NEC CORP), 4 avril 1997 (1997-04-04)**
• **PATENT ABSTRACTS OF JAPAN vol. 010, no. 003
(P-418), 8 janvier 1986 (1986-01-08) & JP 60
160099 A (TOSHIBA KK), 21 août 1985
(1985-08-21)**

**Description**

La présente invention concerne un échantillonneur-bloqueur. Elle s'applique notamment aux échantillonneurs utilisés en amont d'un convertisseur analogique-numérique.

Les systèmes d'acquisition sont généralement constitués d'une chaîne analogique, d'une conversion analogique-numérique et d'une chaîne de traitement numérique. Le développement actuel des technologies tend à déplacer la frontière entre les techniques numériques et les techniques analogiques de plus en plus en amont de la chaîne d'acquisition, pour réduire au maximum la partie analogique. Cela a notamment pour but de simplifier l'architecture matérielle des systèmes en réalisant la plupart des fonctions en techniques numériques, telles que par exemple les fonctions de filtrage ou de modulation, tout en permettant par ailleurs une réduction des coûts de fabrication.

Une conséquence importante de cette évolution est l'énorme accroissement des contraintes reportées sur la partie de conversion analogique-numérique, puisque le convertisseur se trouve alors en tête, ou presque, de la chaîne d'acquisition. Pour illustrer ces contraintes, le cas d'un récepteur hyperfréquence peut pris en considération. Dans ce cas, les structures classiques comportent des transpositions de fréquences, c'est-à-dire que le signal reçu subit un ou plusieurs changements de fréquence avant d'être codé numériquement et démodulé, le codage et la démodulation s'effectuant alors en basse fréquence. Les systèmes de nouvelle génération doivent permettre un codage direct du signal reçu, c'est-à-dire une conversion analogique-numérique, après seulement un premier changement de fréquence, voire directement sur la porteuse. La conversion analogique-numérique doit alors se faire sur des signaux à hautes ou très hautes fréquences. A titre d'exemple, les besoins exigés pour ces systèmes en ce qui concerne les convertisseurs analogique-numérique sont de 10 à 14 bits pour la résolution et la linéarité, de 70 MHz à 900 MHz pour les fréquences d'entrée, et de l'ordre d'un million d'échantillons par seconde à quelques milliards d'échantillons par seconde pour les fréquences de conversion.

Un point clé de ces systèmes devient donc le convertisseur analogique-numérique lui-même. Sa performance est notamment déterminée en grande partie par la qualité d'échantillonnage qu'il comporte en tête de sa structure, c'est-à-dire la fonction d'échantillonnage et de blocage.

La fonction d'un échantillonneur-bloqueur est notamment de recevoir en entrée un signal analogique pouvant varier continûment, et de fournir en sortie un signal dit échantillonné, qui est un signal variant pratiquement par échelons. Le niveau d'un échelon est le niveau qu'avait le signal d'entrée au début de la période d'échantillonnage correspondante, ce niveau étant actualisé à chaque nouvelle période d'échantillonnage.

Un échantillonneur-bloqueur fonctionne en deux phases à chaque période d'échantillonnage. Pendant une brève phase dite « phase d'échantillonnage » ou « sampling phase » dans la littérature anglo-saxonne, la tension de sortie suit les évolutions de la tension d'entrée. Pendant une phase de blocage ou de maintien ou « holding phase » dans la littérature anglo-saxonne, la tension de sortie est bloquée à la valeur qu'elle avait à la fin de la phase d'échantillonnage, malgré les variations de la tension d'entrée.

Le brevêt JP-0 909 1988 montre un échantillonneur -bloqueur conventionnel.

Parmi les qualités attendues d'un échantillonneur-bloqueur, il y a notamment l'exactitude du suivi de la tension d'entrée pendant la phase d'échantillonnage ainsi que la qualité du blocage pendant la phase de maintien. La tension de sortie doit reproduire fidèlement les variations de la tension d'entrée. En ce qui concerne le blocage, la tension de sortie ne doit pas varier à partir du moment où la phase de maintien a commencé. En particulier, il est souhaitable de minimiser l'influence des capacités parasites qui tendent à faire varier la tension de sortie lorsque la tension d'entrée subit des variations rapides.

Une autre qualité attendue est l'aptitude de l'échantillonneur-bloqueur à fonctionner à haute fréquence, notamment pour pouvoir échantillonner des signaux ayant un spectre de fréquence étendu. Ces qualités sont particulièrement importantes pour pouvoir répondre aux exigences de conversion telles que citées précédemment. Une autre qualité attendue est l'aptitude à fonctionner sous faible tension d'alimentation, par exemple sous 5 volts ou 3,3 volts, ou même moins encore. En effet, pour des raisons d'économies d'énergies, les circuits actuels tendent à fonctionner sous des tensions de plus en plus basses.

Un but de l'invention est de permettre la réalisation d'un échantillonneur-bloqueur qui ait les meilleures qualités possibles en ce qui concerne les critères indiqués ci-dessus, et qui soit cependant de conception et de réalisation la plus simple possible, de manière à minimiser l'encombrement, donc le coût du circuit.

A cet effet, l'invention a pour objet un échantillonneur-bloqueur comportant un transistor d'échantillonnage et une capacité d'échantillonnage, le transistor d'échantillonnage étant bloqué en mode de blocage pour empêcher la décharge de la capacité d'échantillonnage et conducteur en mode d'échantillonnage pour appliquer à la capacité une tension sensiblement égale à la tension sur sa base, caractérisé en ce que, en vue d'appliquer sur ladite base en mode bloqué une tension de blocage égale à la tension présente sur la capacité d'échantillonnage, il est prévu un circuit comportant en série, entre deux bornes d'alimentation, deux transistors MOS ayant des canaux drain-source ayant sensiblement le même rapport largeur sur longueur, un transistor bipolaire ayant sa base reliée au point de jonction des deux transistors MOS et son émetteur relié à la base du transistor d'échantillonnage, une diode polarisée par un courant constant, connectée entre la source et la grille d'un des deux transistors MOS, la grille de l'autre étant reliée à la capacité d'échantillonnage.

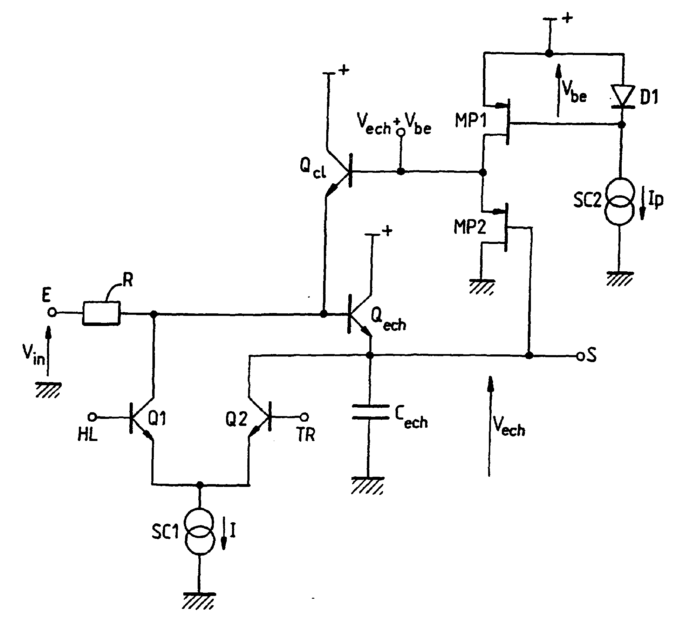

D'autres caractéristiques et avantages de l'invention apparaîtront à la lecture de la description détaillée qui suit et qui est faite en référence au dessin annexé dans lequel l'unique figure représente, par un schéma de principe, un exemple de réalisation d'un échantillonneur-bloqueur selon l'invention.

L'échantillonneur-bloqueur comprend une entrée E et une capacité d'échantillonnage $C_{ech}$ aux bornes de laquelle le niveau de tension Vin présent sur l'entrée E est maintenu jusqu'à l'instant d'échantillonnage suivant.

Un transistor d'échantillonnage $Q_{ech}$, conducteur pendant la phase d'échantillonnage et bloqué pendant la phase de maintien, dite encore de blocage, a son émetteur relié à une borne de la capacité d'échantillonnage $C_{ech}$, sa base étant par exemple reliée à l'entrée E via une résistance R. Le collecteur du transistor $Q_{ech}$ est relié à une alimentation positive. L'autre borne de la capacité $Q_{ech}$ est reliée par exemple à un potentiel de masse du circuit. Lorsque le transistor $Q_{ech}$ est conducteur, il applique sur son émetteur la tension qui est présente sur sa base avec un décalage de tension égal à une tension émetteur-base Vbe qui varie classiquement de 0,6 à 0,7 volts. Ce transistor est donc monté en suiveur. La sortie S de l'échantillonneur-bloqueur est prise à la jonction de la capacité d'échantillonnage $C_{ech}$ et de l'émetteur d'échantillonnage $Q_{ech}$.

Un circuit d'entrée permet de bloquer et rendre conducteur le transistor d'échantillonnage $Q_{ech}$. Ce circuit comporte par exemple une paire de transistors Q1, Q2 dont les émetteurs sont reliés à une source de courant SC1. Le collecteur d'un premier transistor Q1 est relié à la base du transistor d'échantillonnage $Q_{ech}$ et le collecteur du deuxième transistor Q2 est relié à l'émetteur du transistor d'échantillonnage $Q_{ech}$, ainsi qu'à la capacité d'échantillonnage $C_{ech}$. Le premier transistor Q1 a sa base commandée par un signal HL actif pendant la phase de maintien. Il est donc conducteur pendant cette phase. Il tire alors vers le bas le potentiel de base du transistor d'échantillonnage pour le bloquer. Le deuxième transistor Q2 a sa base commandée par un signal TR actif pendant la phase d'échantillonnage. Il est donc conducteur pendant cette phase. Il permet alors à l'émetteur du transistor d'échantillonnage d'être alimenté en courant par la source SC1 de sorte que ce transistor fonctionne en suiveur pendant la phase d'échantillonnage. Les signaux TR et HL sont complémentaires, c'est-à-dire que l'un est au niveau haut quand l'autre est au niveau bas et vice-versa.

L'échantillonneur-bloqueur comporte un circuit suiveur en sortie d'émetteur du transistor d'échantillonnage $Q_{ech}$ et qui est rebouclé sur la base de ce dernier. La fonction de ce circuit est notamment d'assurer que la tension appliquée sur la base du transistor d'échantillonnage $Q_{ech}$ en mode bloqué est égale à la tension présente sur l'émetteur de ce transistor $Q_{ech}$, c'est-à-dire la tension de sortie S présente sur la capacité d'échantillonnage $C_{ech}$. Cela assure notamment le blocage de ce transistor tout en réduisant la transmission par influence capacitive des variations de la tension d'entrée vers la tension présente sur la capacité d'échantillonnage $C_{ech}$, cette transmission étant essentiellement due à la capacité de jonction entre la base et l'émetteur du transistor d'échantillonnage $Q_{ech}$.

Le circuit suiveur comporte en série, entre deux bornes d'alimentation positives, deux transistors MP1, MP2 de type MOS, un transistor bipolaire Qcl, et une diode D1 polarisée par un courant Ip, par exemple constant.

Le transistor bipolaire Qcl a sa base reliée au point de jonction des deux transistors MP1, MP2 de type MOS et son émetteur relié à la base du transistor d'échantillonnage $Q_{ech}$. Le collecteur du transistor bipolaire Qcl est par exemple relié à une borne d'alimentation positive. La diode est connectée entre la source et la grille d'un des deux transistors MP1, la grille du deuxième transistor MP2 étant reliée à la capacité d'échantillonnage $C_{ech}$. Le courant de polarisation Ip est par exemple fourni à la diode D1 par une source de courant SC2 connectée entre la cathode de la diode D1 et une borne d'alimentation, par exemple le potentiel de masse.

On note $V_{ech}$ la tension d'échantillonnage aux bornes de la capacité d'échantillonnage $C_{ech}$. Selon l'invention, le circuit suiveur permet, en choisissant astucieusement les transistors de type MOS MP1, MP2, d'imposer le potentiel présent sur la base du transistor bipolaire Qcl à la valeur $V_{ech}$ + Vbe, où Vbe est le potentiel base-émetteur de ce transistor Qcl, mais aussi du transistor d'échantillonnage $Q_{ech}$. On peut en particulier supposer que les deux transistors ont même tension base-émetteur puisque celle-ci provient de leurs jonctions PN, dont la tension est parfaitement définie en fonction de la température. Par construction, les deux transistors Qcl et $Q_{ech}$ sont très proches et ont donc mêmes températures de jonction, donc mêmes tensions base-émetteur Vbe.

La tension présente sur la base du transistor bipolaire Qcl étant égal à $V_{ech}$ + Vbe, il en résulte que la tension présente sur son émetteur, qui est égal à sa tension de base diminuée de sa tension base-émetteur, est égale à ($V_{ech}$ + Vbe) - Vbe = $V_{ech}$, c'est-à-dire égale à la tension d'échantillonnage.

La diode D1 étant parcourue par son courant de polarisation Ip, elle présente à ses bornes une tension de jonction qui est égale à la tension base-émetteur Vbe des deux transistors Qcl et $Q_{ech}$, pour les mêmes raisons que celles qui font que les tensions base-émetteur de ces deux transistors sont les mêmes. Les deux transistors MP1, MP2 étant par exemple de type PMOS, l'anode de la diode D1 est reliée à la source du premier transistor MP1 et sa cathode est reliée à la grille de ce dernier. Il en résulte que la tension entre la source et la grille du premier transistor est égale à la tension de jonction de la diode Vbe, ou tension base-émetteur des transistors Qcl et Tec. La source du premier transistor MOS MP1 est par exemple reliée à une borne d'alimentation positive et le drain du deuxième transistor MOS MP2 est par exemple relié à une deuxième borne d'alimentation, de potentiel inférieur, par exemple le potentiel de masse.

Par ailleurs, le courant drain Id passant dans les deux transistors répond aux relations suivantes :

$$Id = \mu cos[(W_1/L_1)(Vgs_1 - Vs)^2] \qquad\qquad (1)$$

et

$$Id = \mu cos[(W_2/L_2)(Vgs_2 - Vs)^2] \qquad\qquad (2)$$

où:

- $\mu$ est une constante propre aux transistors de type MOS ;
- $W_1$ et $W_2$ sont respectivement les largeurs du canal entre le drain et la source du premier et du deuxième transistor MOS ;
- $L_1$ et $L_2$ sont respectivement les longueurs du canal entre le drain et la source du premier et du deuxième transistor MOS ;
- $Vgs_1$ et $Vgs_2$ sont respectivement les tensions entre la grille et la source du premier et du deuxième transistor MOS ;
- Vs est une tension de seul propre à un transistor MOS.

En choisissant de transistors MP1, MP2 tels que leurs rapports largeur sur longueur de canal soit égaux, c'est-à-dire $(W_1/L_1) = (W_2/L_2)$, il s'ensuit que les relations (1) et (2) imposent une égalité des tensions grille-source, soit $Vgs_1 = Vgs_2$, puisque le courant drain est le même dans chaque transistor.

En pratique, pour obtenir des transistors ayant des canaux drain-source ayant sensiblement le même rapport longueur sur largeur, il suffit de sélectionner des transistors bien appairés. Des mesures d'appariement peuvent se faire par des tests électriques connus.

Etant donné que la tension grille-source $Vgs_1$ du premier transistor MP1 est égale à la tension Vbe, il en résulte que la tension grille-source $Vgs_2$ du deuxième transistor MP2 est égale aussi à cette tension Vbe. Or, cette tension grille-source $Vgs_2$ est aussi la tension entre l'émetteur du transistor d'échantillonnage $Q_{ech}$ et la base du transistor bipolaire Qcl, de sorte que la tension présente sur cette base est égale à la tension d'échantillonnage augmentée de la tension base-émetteur, $V_{ech}$ + Vbe.

Le décalage de tension -Vbe du transistor bipolaire Qcl compense le décalage de tension Vbe introduit par les deux transistors MOS associés à la diode D1, de telle sorte que la base du transistor d'échantillonnage reste au potentiel $V_{ech}$ de la sortie S. Ceci n'est vrai que si le transistor bipolaire Qcl est conducteur, et ce transistor Qcl n'est conducteur qu'en mode de blocage grâce au premier transistor Q1 du circuit d'entrée qui permet l'évacuation de son courant.

Il n'est pas utile que le courant de polarisation Ip de la diode D1 soit précis. Il suffit que les tensions Vbe des transistors Qcl, $Q_{ech}$ et de la diode D1 soient sensiblement identiques au cours du temps, notamment au cours des dérives en températures de leur environnement. La source de courant SC2 peut donc être réalisée simplement et à bon marché. En particulier elle peut être réalisée soit par un transistor bipolaire de type NPN, soit par un transistor de type NMOS, soit encore par une simple résistance, suivant les éléments disponibles dans la technologie considérée.

Le circuit d'entrée composé d'une résistance R et d'une paire de transistors Q1, Q2 tel que représenté par la figure est ici dans sa version la plus simple. Il est bien sûr possible de prévoir d'autres types de circuits d'entrées.

**Revendications**

1. Echantillonneur-bloqueur comportant un transistor d'échantillonnage ($Q_{ech}$) et une capacité d'échantillonnage ($C_{ech}$), le transistor d'échantillonnage étant bloqué en mode de blocage pour empêcher la décharge de la capacité d'échantillonnage et conducteur en mode d'échantillonnage pour appliquer à la capacité une tension sensiblement égale à la tension sur sa base, **caractérisé en ce que**, en vue d'appliquer sur ladite base en mode bloqué une tension de blocage égale à la tension ($V_{ech}$) présente sur la capacité d'échantillonnage, il est prévu un circuit comportant en série, entre deux bornes d'alimentation, deux transistors de type MOS (MP1, MP2) ayant des canaux drain-source ayant sensiblement le même rapport largeur sur longueur, un transistor bipolaire (Qcl) ayant sa base reliée au point de jonction des deux transistors MOS et son émetteur relié à la base du transistor d'échantillonnage ($Q_{ech}$), et une diode (D1) polarisée par un courant (Ip), connectée entre la source et la grille d'un des deux transistors MOS (MP1), la grille de l'autre transistor MOS (MP2) étant reliée à la capacité d'échantillonnage.

2. Echantillonneur-bloqueur selon la revendication 1, **caractérisé en ce que** les deux transistors du type MOS (MP1, MP2) étant des transistors PMOS, la source et la grille d'un premier transistor (MP1) sont respectivement reliées à l'anode et à la cathode de la diode (D1),la grille et le drain du deuxième transistor (MP2) étant respectivement reliés à la capacité d'échantillonnage ($C_{ech}$) et à une borne d'alimentation de potentiel inférieur au potentiel d'alimentation auquel est relié la source du premier transistor (MP1).

3. Echantillonneur-bloqueur selon l'une quelconque des revendications précédentes, **caractérisé en ce que** le courant de polarisation (Ip) de la diode est fourni par une source de courant (SC2) connectée entre la cathode de la diode (D1) et une borne d'alimentation.

4. Echantillonneur-bloqueur selon la revendication 3, **caractérisé en ce que** la source d'alimentation est réalisée par un transistor bipolaire de type NPN.

5. Echantillonneur-bloqueur selon la revendication 3, **caractérisé en ce que** la source d'alimentation est réalisée par un transistor de type NMOS.

6. Echantillonneur-bloqueur selon la revendication 3, **caractérisé en ce que** la source d'alimentation est réalisée par une résistance.

7. Echantillonneur-bloqueur selon l'une quelconque des revendications précédentes, **caractérisé en ce qu'**il comporte une paire de transistors (Q1, Q2) dont les émetteurs sont reliés à une source de courant (SC1), le collecteur d'un premier transistor (Q1) étant relié à la base du transistor d'échantillonnage ($Q_{ech}$) et le collecteur du deuxième transistor (Q2) étant relié à l'émetteur du transistor d'échantillonnage ($Q_{ech}$), le premier transistor Q1 ayant sa base commandée par un signal (HL) actif pendant la phase de maintien, le deuxième transistor (Q2) ayant sa base commandée par un signal (TR) actif pendant la phase d'échantillonnage, ces signaux (TR, HL) étant complémentaires.

## Claims

1. Sample-and-hold circuit comprising a sampling transistor ($Q_{ech}$) and a sampling capacitor ($C_{ech}$), the sampling transistor being in the off-state in hold mode to prevent discharge of the sampling capacitor and in the on-state in sample mode so as to apply to the capacitor a voltage approximately equal to the voltage at its base, **characterized in that**, with a view to applying to said base in holding mode a hold voltage equal to the voltage ($V_{ech}$) present on the sampling capacitor, a circuit is provided comprising in series, between two power supply terminals, two MOS transistors (MP1, MP2) with drain-source channels of approximately the same width/length ratio, a bipolar transistor ($Q_{cl}$) with its base connected to the point of the junction of the two MOS transistors and its emitter connected to the base of the sampling transistor ($Q_{ech}$), and a diode (D1) biased by a current (Ip), connected between the source and the gate of one of the two MOS transistors (MP1), the gate of the other MOS transistor (MP2) being connected to the sampling capacitor.

2. Sample-and-hold circuit according to Claim 1, **characterized in that**, the two MOS transistors (MP1, MP2) being PMOS transistors, the source and the gate of a first transistor (MP1) are connected respectively to the anode and to the cathode of the diode (D1), the gate and the drain of the second transistor (MP2) being connected respectively to the sampling capacitor ($C_{ech}$) and to a power supply terminal at a potential lower than the supply potential to which the source of the first transistor (MP1) is connected.

3. Sample-and-hold circuit according to either of the preceding claims, **characterized in that** the bias current ($I_P$) of the diode is provided by a current source (SC2) connected between the cathode of the diode (D1) and a power supply terminal.

4. Sample-and-hold circuit according to Claim 3, **characterized in that** the power is supplied via an NPN bipolar transistor.

5. Sample-and-hold circuit according to Claim 3, **characterized in that** the power is supplied via an nMOS transistor.

**6.** Sample-and-hold circuit according to Claim 3, **characterized in that** the power is supplied via a resistor.

**7.** Sample-and-hold circuit according to any one of the preceding claims, **characterized in that** it comprises a pair of transistors (Q1, Q2), the emitters of which are connected to a current source (SC1), the collector of a first transistor (Q1) being connected to the base of the sampling transistor ($Q_{ech}$) and the collector of the second transistor (Q2) being connected to the emitter of the sampling transistor ($Q_{ech}$), the first transistor Q1 having its base controlled by a signal (HL) that is active during the holding phase, the second transistor (Q2) having its base controlled by a signal (TR) that is active during the sampling phase, these signals (TR, HL) being complementary.

**Patentansprüche**

**1.** Abtast- und Halteschaltung, die einen Abtasttransistor ($Q_{ech}$) sowie eine Abtastkapazität ($C_{ech}$) aufweist, wobei der Abtasttransistor im Haltemodus blockiert ist, um das Entladen der Abtastkapazität zu verhindern, und im Abtastmodus leitend ist, um an die Kapazität eine Spannung im Wesentlichen gleich der Spannung an ihrer Basis anzulegen, **dadurch gekennzeichnet, dass** zum Anlegen an der Basis im Haltemodus einer Haltespannung gleich der Spannung ($V_{ech}$), die auf der Abtastkapazität gegenwärtig ist, eine Schaltung vorgesehen ist, die in Serie zwischen zwei Versorgungsklemmen zwei Transistoren des Typs MOS (MP1, MP2) aufweist, die Drain-Source-Kanäle haben, die im Wesentlichen das gleiche Verhältnis Breite zu Länge haben, einen bipolaren Transistor (Qcl), dessen Basis mit dem Verbindungspunkt der zwei MOS-Transistoren verbunden ist und dessen Sender mit der Basis des Abtasttransistors ($Q_{ech}$) verbunden ist, eine Diode (D1), die von einem Strom (lp) polarisiert ist, die zwischen der Quelle und dem Gate eines der zwei MOS-Transistoren (MP1) angeschlossen ist, wobei das Gate des anderen MOS-Transistors (MP2) mit der Abtastkapazität verbunden ist.

**2.** Abtast- und Halteschaltung nach Anspruch 1, **dadurch gekennzeichnet, dass**, da die zwei Transistoren des Typs MOS (MP1, MP2) PMOS-Transistoren sind, die Quelle und das Gate eines ersten Transistors (MP1) jeweils mit der Anode und der Kathode der Diode (D1) verbunden sind, wobei das Gate und der Drain des zweiten Transistors (MP2) jeweils mit der Abtastkapazität ($C_{ech}$) und einer Versorgungsklemme mit kleinerem Potenzial als das Versorgungspotenzial, an das die Quelle des ersten Transistors (MP1) angeschlossen ist, verbunden sind.

**3.** Abtast- und Halteschaltung nach einem der vorhergehenden Ansprüche, **dadurch gekennzeichnet, dass** der Polarisierungsstrom (lp) der Diode von einer Stromquelle (SC2) geliefert wird, die zwischen der Kathode der Diode (D1) und einer Versorgungsklemme angeschlossen ist.

**4.** Abtast- und Halteschaltung nach Anspruch 3, **dadurch gekennzeichnet, dass** die Versorgungsquelle aus einem bipolaren Transistor des Typs NPN besteht.

**5.** Abtast- und Halteschaltung nach Anspruch 3, **dadurch gekennzeichnet, dass** die Versorgungsquelle aus einem Transistor des Typs NMOS besteht.

**6.** Abtast- und Halteschaltung nach Anspruch 3, **dadurch gekennzeichnet, dass** die Versorgungsquelle aus einem Widerstand besteht.

**7.** Abtast- und Halteschaltung nach einem der vorhergehenden Ansprüche, **dadurch gekennzeichnet, dass** sie ein Paar Transistoren (Q1, Q2) aufweist, deren Sender mit einer Stromquelle (SC1) verbunden sind, wobei der Kollektor eines ersten Transistors (Q1) mit der Basis des Abtasttransistors ($Q_{ech}$) verbunden ist, und der Kollektor des zweiten Transistors (Q2) mit dem Sender des Abtasttransistors ($Q_{ech}$) verbunden ist, wobei die Basis des ersten Transistors (Q1) von einem Signal (HL) gesteuert wird, das während der Haltephase aktiv ist, wobei die Basis des zweiten Transistors (Q2) von einem Signal (TR) gesteuert wird, das während der Abtastphase aktiv ist, wobei diese Signale (TR, HL) komplementär sind.

**EP 1 074 996 B1**

## RÉFÉRENCES CITÉES DANS LA DESCRIPTION

**Documents brevets cités dans la description**

- JP 09091988 B